(19) Europäisches Patentamt
European Patent Office
Office européen des brevets

(11) **EP 4 524 586 A1**

(12) **EUROPEAN PATENT APPLICATION**

(43) Date of publication:
**19.03.2025 Bulletin 2025/12**

(21) Application number: **24152066.7**

(22) Date of filing: **16.01.2024**

(51) International Patent Classification (IPC):
**G01R 31/392** (2019.01)   **G01R 31/367** (2019.01)

(52) Cooperative Patent Classification (CPC):
**G01R 31/392; G01R 31/367**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **15.09.2023 CN 202311189164**

(71) Applicant: **Eneroc New Energy Technology Co., Ltd**
**311407 Hangzhou City Zhejiang (CN)**

(72) Inventors:
• **KONG, Debao**
**Hangzhou City, Zhejiang 311407 (CN)**

• **CAO, Jiawei**
**Hangzhou City, Zhejiang 311407 (CN)**
• **MA, Shuai**
**Hangzhou City, Zhejiang 311407 (CN)**
• **LIU, Yongqing**
**Hangzhou City, Zhejiang 311407 (CN)**
• **XU, Qi**
**Hangzhou City, Zhejiang 311407 (CN)**

(74) Representative: **MERH-IP Matias Erny Reichl Hoffmann**
**Patentanwälte PartG mbB**
**Paul-Heyse-Straße 29**
**80336 München (DE)**

Remarks:
MISSING OR CORRECT PARTS INCLUDED UNDER RULE 56(3) OR RULE 56a(4) EPC

(54) **STATE OF HEALTH (SOH) ESTIMATION METHOD AND SYSTEM FOR LITHIUM BATTERY**

(57) The present disclosure discloses a state of health (SOH) estimation method and system for a lithium battery. The method includes obtaining battery life attenuation factors; performing a battery cell life test based on the battery life attenuation factors to determine a battery SOH value of a corrected part; performing the battery cell life test to determine a battery SOH value of an aging mechanism part; constructing an SOH model based on the battery life attenuation factors, the corresponding battery SOH value of the corrected part, and the corresponding battery SOH value of the aging mechanism part, where the SOH model takes the battery life attenuation factors as an input and a sum of the battery SOH value of the aging mechanism part and the battery SOH value of the corrected part as an output; and estimating an SOH of a lithium battery to be estimated by using the SOH model.

FIG. 1

**Description**

**TECHNICAL FIELD**

The present disclosure relates to the field of state of health (SOH) estimation of a lithium battery, and in particular, to an SOH estimation method and system for a lithium battery.

**BACKGROUND**

Lithium-ion batteries are mainly used as traction batteries in the field of new energy vehicles, but the life of lithium batteries will gradually decline with extension of shelving time, an increase in number of cycles, and other factors. An SOH of batteries has aroused widespread attention of researchers. The SOH represents a ratio of a fully charged capacity of the battery under current conditions to a rated capacity at delivery. It is generally believed that 70%SOH is the service life limit of the battery, and the battery needs to be replaced with a new one at this time. The SOH directly affects the service life of the battery and an endurance mileage of a vehicle. Accurate estimation of the SOH is also related to estimation of a state of charge (SOC) of the battery and affects experience of a vehicle user.

Common SOH estimation methods in engineering mainly include a direct current internal resistance (DCR) estimation method, an open circuit voltage (OCV) calibration method, and the like. The DCR estimation method is to obtain an internal resistance increment based on DCR testing, and look up an internal resistance increment-capacity fading table to determine a capacity fading value, so as to estimate an SOH. The DCR estimation method has convenience in testing, but it is difficult to obtain a peak current during calculation of internal resistance, and the method relies heavily on synchronization of voltage and current sampling, so that a large error is likely to occur in calculation of the internal resistance, and the SOH obtained by looking up the table based on the internal resistance increment may be inaccurate. The OCV calibration method is to check an SOC based on to an OCV in a steep range of an OCV curve, and calculate an SOH based on a recorded ampere-hour integral variation and SOC variation. The OCV calibration method is relatively simple, but this SOH estimation method relies heavily on accuracy of an OCV-SOC curve, and is restricted by a static battery condition, so that accuracy of SOH estimation is limited.

Therefore, there is an urgent need to provide an SOH estimation method or system for a lithium battery, which can solve the problem of large errors in SOH estimation of a lithium battery, thereby accurately estimating an SOH.

**SUMMARY**

An objective of the present disclosure is to provide an SOH estimation method and system for a lithium battery, which can accurately estimate an SOH.

To achieve the above objective, the present disclosure provides the following solutions.

An SOH estimation method for a lithium battery includes:

obtaining battery life attenuation factors, where the battery life attenuation factors include: a temperature T, a battery SOC, a number of cycles, and a shelving time t; and the number of cycles is expressed by a capacity throughput E;

performing a battery cell life test based on the battery life attenuation factors to determine a battery SOH value of a corrected part;

performing the battery cell life test based on the battery life attenuation factors to determine a battery SOH value of an aging mechanism part;

constructing an SOH model based on the battery life attenuation factors, the corresponding battery SOH value of the corrected part, and the corresponding battery SOH value of the aging mechanism part, where the SOH model takes the battery life attenuation factors as an input and a sum of the battery SOH value of the aging mechanism part and the battery SOH value of the corrected part as an output; and

estimating an SOH of a lithium battery to be estimated by using the SOH model.

Optionally, the performing a battery cell life test based on the battery life attenuation factors to determine a battery SOH value of a corrected part specifically includes:

determining the battery SOH value of the corrected part by using formula

$$\Delta SOH_{correct} = \Delta SOH_{correct\_pre} \times a + \left(SOH - SOH_{pre}\right) \times (1 - a),$$

where $\Delta SOH_{correct}$ is a battery SOH value of the corrected part at a current time, $\Delta SOH_{correct\_pre}$ is a battery SOH correction amount at a previous time, SOH is a battery SOH value at the current time, $SOH_{pre}$ is a battery SOH value at the previous time, a is a first-order filter coefficient, and an initial value of $\Delta SOH_{correct}$ is 0.

Optionally, the performing the battery cell life test based on the battery life attenuation factors to determine a battery SOH value of an aging mechanism part specifically includes:

performing the battery cell life test based on the battery life attenuation factors, where the battery cell life test includes: a shelving test and an application condition cycling test; and performing capacity calibration once a month to check a battery SOH variation;

using a lsqcurvefit function for fitting based on a correspondence between the battery life attenuation factors and a capacity variation to determine calendar life parameters and cycle life parameters, where the calendar life parameter includes: a calendar pre-exponential factor $\alpha1$, a calendar temperature factor $\beta1$, a calendar coefficient $\gamma1$, and a calendar SOC factor 0; and the cycle life parameter includes: a cycling pre-exponential factor $\alpha2$, a cycling temperature factor $\beta2$, and a cycling coefficient $\gamma2$;

determining a calendar life attenuation amount and a cycle life attenuation amount based on the calendar life parameters and the cycle life parameters; and

determining the battery SOH value of the aging mechanism part based on the calendar life attenuation amount and the cycle life attenuation amount.

Optionally, the determining a calendar life attenuation amount and a cycle life attenuation amount based on the calendar life parameters and the cycle life parameters specifically includes:

determining a calendar capacity variation by using formula

$$dCap1 = \alpha1 \times e^{-\beta1/T} \times t^{\gamma1} \times SOC^{\theta};$$

determining a cycling capacity variation by using formula $dCap2 = \alpha2 \times e^{-\beta2/T} \times E^{\gamma2}$;

obtaining a quotient of the calendar capacity variation dCap1 and a rated capacity Q0 to obtain the calendar life attenuation amount $\Delta SOH_{calendar}$; and

obtaining a quotient of the cycling capacity variation dCap2 and the rated capacity Q0 to obtain the cycle life attenuation amount $\Delta SOH_{cycle}$.

Optionally, the determining the battery SOH value of the aging mechanism part based on the calendar life attenuation amount and the cycle life attenuation amount specifically includes:

determining the battery SOH value $SOH_{calculate}$ of the aging mechanism part by using formula $SOH_{calculate} = 100\% - (\Delta SOH_{calendar} + \Delta SOH_{cycle})$.

An SOH estimation system for a lithium battery includes:

a battery life attenuation factor acquisition module, configured to obtain battery life attenuation factors, where the battery life attenuation factors include: a temperature T, a battery SOC, a number of cycles, and a shelving time t; and the number of cycles is expressed by a capacity throughput E;

a module for determining a battery SOH value of a corrected part, configured to perform a battery cell life test based on the battery life attenuation factors to determine a battery SOH value of a corrected part;

a module for determining a battery SOH value of an aging mechanism part, configured to perform a battery cell life test based on the battery life attenuation factors to determine a battery SOH value of an aging mechanism part;

an SOH model construction module, configured to construct an SOH model based on the battery life attenuation factors, the corresponding battery SOH value of the corrected part, and the corresponding battery SOH value of the aging mechanism part, where the SOH model takes the battery life attenuation factors as an input and a sum of the battery SOH value of the aging mechanism part and the battery SOH value of the corrected part as an output; and

an SOH estimation module, configured to estimate an SOH of a lithium battery to be estimated by using the SOH model.

According to specific embodiments of the present disclosure, the present disclosure has the following technical effects:

In the SOH estimation method and system for a lithium battery, a battery SOH value of a corrected part and a battery SOH value of an aging mechanism part are determined based on a battery cell life test, and then an SOH is estimated; estimating the SOH based on battery life test data overcomes high dependence of a DCR estimation method on synchronization of voltage and current sampling; and the present disclosure is not restricted by a static condition, and avoids the dependence of an OCV calibration method on accuracy of an OCV-SOC curve.

**BRIEF DESCRIPTION OF THE DRAWINGS**

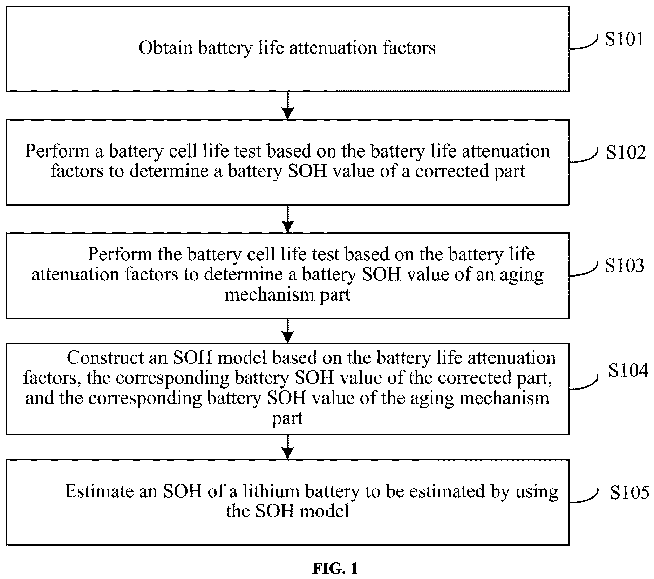

To describe the technical solutions in embodiments of the present disclosure or in the prior art more clearly, the accompanying drawings required for the embodiments are briefly described below. Apparently, the accompanying drawings in the following description show merely some embodiments of the present disclosure, and those of ordinary skill in the art may still derive other accompanying drawings from these accompanying drawings without creative efforts. FIG. 1 is a schematic flowchart of an SOH estimation method for a lithium battery according to the present disclosure.

**DETAILED DESCRIPTION OF THE EMBODIMENTS**

The technical solutions of the embodiments of the present disclosure are clearly and completely described below with reference to the accompanying drawings in the embodiments of the present disclosure. Apparently, the described embodiments are merely some rather than all of the embodiments of the present disclosure. All other embodiments obtained by those skilled in the art based on the embodiments of the present disclosure without creative efforts shall fall within the protection scope of the present disclosure.

An objective of the present disclosure is to provide an SOH estimation method and system for a lithium battery, which can accurately estimate an SOH.

In order to make the above objective, features and advantages of the present disclosure clearer and more comprehensible, the present disclosure will be further described in detail below in combination with accompanying drawings and specific implementations.

As shown in FIG. 1, an SOH estimation method for a lithium battery according to the present disclosure includes the following steps.

S101: Obtain battery life attenuation factors, where the battery life attenuation factors include: a temperature T, a battery SOC, a number of cycles, and a shelving time t; and the number of cycles is expressed by a capacity throughput E.

A higher temperature indicates a higher electrochemical reaction rate and faster capacity fading; a higher SOC indicates a higher electrolyte decomposition rate, higher consumption of active lithium and faster battery aging; a larger number of cycles, that is, a greater capacity throughput, indicates a faster battery loss and faster capacity fading; and a longer shelving time of a battery indicates more severe battery self-discharge and faster capacity fading.

S102: Perform a battery cell life test based on the battery life attenuation factors to determine a battery SOH value of a corrected part.

This step specifically includes:

determining the battery SOH value of the corrected part by using formula

$$\Delta SOH_{correct} = \Delta SOH_{correct\_pre} \times a + \left(SOH - SOH_{pre}\right) \times \left(1 - a\right),$$

where $\Delta SOH_{correct}$ is a battery SOH value of the corrected part at a current time, $\Delta SOH_{correct\_pre}$ is a battery SOH correction amount at a previous time, SOH is a battery SOH value at the current time, $SOH_{pre}$ is a battery SOH value at the previous time, a is a first-order filter coefficient, and an initial value of $\Delta SOH_{correct}$ is 0.

S103: Perform the battery cell life test based on the battery life attenuation factors to determine a battery SOH value of an aging mechanism part.

Step S103 specifically includes:
performing the battery cell life test based on the battery life attenuation factors, where the battery cell life test includes: a shelving test and an application condition cycling test; and performing capacity calibration once a month to check a battery SOH variation.

The performing the battery cell life test specifically includes the following steps.

S1: Arrange and combine SOCs and temperatures T, and perform shelving tests at corresponding SOCs and temperatures T respectively to obtain SOH calendar life variations, where selected SOCs and temperatures T should cover each range.

S2: Arrange and combine the temperatures T, and perform application condition cycling tests at the corresponding temperatures T respectively to obtain SOH cycle life variations, where the selected temperatures T should cover each range.

S3: Use two packs of battery cells as parallel samples under each working condition for the shelving tests and the cycling tests to obtain shelving test data and application condition cycling test data, where the two packs of battery cells are under the same working condition to reduce the influence of experimental errors.

S4: Perform capacity calibration once a month to obtain a variation dCap1 of a shelving test capacity and a variation dCap2 of a cycling test capacity.

There are 9 corresponding shelving test conditions. Two packs of new battery cells in the same state are selected as parallel samples for each working condition, and shelving is performed in the case of 20%SOC at 10°C, 50%SOC at 10°C, 100%SOC at 10°C, 20%SOC at 25°C, 50%SOC at 25°C, 100%SOC at 25°C, 20%SOC at 35°C, 50%SOC at 35°C, and 100%SOC at 35°C. The shelving time t is counted from 0, and each month is used as an SOH inspection cycle. The capacity variation is calculated by capacity calibration until the SOH is reduced to 70%.

For application condition cycling tests, specific implementation examples are as follows.

For example, the temperature T is set to 10°C, 25°C, 35°C, 45°C, and 55°C.

There are 5 corresponding application condition cycling test conditions. Two packs of new battery cells in the same state are selected as parallel samples for each working condition, and cycling is performed at 10°C, 25°C, 35°C, 45°C, and 55°C. The number of cycles is represented by the capacity throughput E (in Ah). E is counted from 0, and each month is used as an SOH inspection cycle. The capacity variation is calculated by capacity calibration until the SOH is reduced to 70%.

A lsqcurvefit function is used for fitting based on a correspondence between the battery life attenuation factors and a capacity variation to determine calendar life parameters and cycle life parameters, where the calendar life parameter includes: a calendar pre-exponential factor $\alpha1$, a calendar temperature factor $\beta1$, a calendar coefficient $\gamma1$, and a calendar SOC factor $\theta$; and the cycle life parameter includes: a cycling pre-exponential factor $\alpha2$, a cycling temperature factor $\beta2$, and a cycling coefficient $\gamma2$.

A calendar life attenuation amount and a cycle life attenuation amount are determined based on the calendar life parameters and the cycle life parameters.

The battery SOH value of the aging mechanism part is determined based on the calendar life attenuation amount and the cycle life attenuation amount.

A calendar capacity variation is determined by using formula

$$dCap1 = \alpha1 \times e^{-\beta1/T} \times t^{\gamma1} \times SOC^{\theta}.$$

A cycling capacity variation is determined by using formula $dCap2 = \alpha2 \times e^{-\beta2/T} \times E^{\gamma2}$.

A quotient of the calendar capacity variation dCap1 and a rated capacity Q0 is obtained to obtain the calendar life attenuation amount $\Delta SOH_{calendar}$.

A quotient of the cycling capacity variation dCap2 and the rated capacity Q0 is obtained to obtain the cycle life attenuation amount $\Delta SOH_{cycle}$.

The battery SOH value $SOH_{calculate}$ of the aging mechanism part is determined by using formula $SOH_{calculate}$ = 100% - ($\Delta SOH_{calendar}$ + $\Delta SOH_{cycle}$).

A change rate of the SOH is limited, and a Simulink model changes by 0.01 %SOH at most for each calculation.

The SOH of the lithium battery is not corrected upward, and the SOH value is between 70% and 100%.

S104: Construct an SOH model based on the battery life attenuation factors, the corresponding battery SOH value of the corrected part, and the corresponding battery SOH value of the aging mechanism part, where the SOH model takes the battery life attenuation factors as an input and a sum of the battery SOH value of the aging mechanism part and the battery SOH value of the corrected part as an output.

The SOH model is:

SOH = $SOH_{calculate}$ + $\Delta SOH_{correct}$ or SOH = fcn(t,T,SOC,E) + $\Delta SOH_{correct}$, where $SOH_{calculate}$ is fcn(t,T,SOC,E) and represents a calculated SOH of the aging mechanism part. $\Delta SOH_{correct}$ represents the battery SOH value of the corrected part, which is calculated based on first-order filtering of the SOH variation.

S105: Estimate an SOH of a lithium battery to be estimated by using the SOH model.

The present disclosure provides the SOH estimation method for a lithium battery based on a battery cell life test, which fits test data by using empirical formula and the isqcurvefit function, and calculates the SOH of the aging mechanism part from two aspects of calendar life and cycle life, to accurately estimate the SOH, thereby solving the problem of large errors in SOH estimation of the lithium battery. Estimating the SOH based on systematic battery life test data overcomes high dependence of a DCR estimation method on synchronization of voltage and current sampling; and the method is not restricted by a static condition, and avoids the dependence of an OCV calibration method on accuracy of an OCV-SOC curve.

Corresponding to the method of the above embodiment, the present disclosure further provides an SOH estimation system for a lithium battery, including:

a battery life attenuation factor acquisition module, configured to obtain battery life attenuation factors, where the battery life attenuation factors include: a temperature T, a battery SOC, a number of cycles, and a shelving time t; and the number of cycles is expressed by a capacity throughput E;

a module for determining a battery SOH value of a corrected part, configured to perform a battery cell life test based on the battery life attenuation factors to determine a battery SOH value of a corrected part;

a module for determining a battery SOH value of an aging mechanism part, configured to perform a battery cell life test based on the battery life attenuation factors to determine a battery SOH value of an aging mechanism part;

an SOH model construction module, configured to construct an SOH model based on the battery life attenuation factors, the corresponding battery SOH value of the corrected part, and the corresponding battery SOH value of the aging mechanism part, where the SOH model takes the battery life attenuation factors as an input and a sum of the battery SOH value of the aging mechanism part and the battery SOH value of the corrected part as an output; and

an SOH estimation module, configured to estimate an SOH of a lithium battery to be estimated by using the SOH model.

Embodiments of this description are described in a progressive manner, each embodiment focuses on the difference from other embodiments, and for the same and similar parts between the embodiments, reference may be made to each other. Since the system disclosed in an embodiment corresponds to the method disclosed in an embodiment, the description is relatively simple, and for related contents, reference may be made to the description of the method.

Specific examples are used herein for illustration of principles and implementations of the present disclosure. The descriptions of the above embodiments are merely used for assisting in understanding the method of the present disclosure and its core ideas. In addition, those of ordinary skill in the art can make various changes in terms of specific implementations and the scope of application in accordance with the ideas of the present disclosure. In conclusion, the content of this description shall not be construed as limitations to the present disclosure.

## Claims

1. A state of health (SOH) estimation method for a lithium battery, comprising:

    obtaining battery life attenuation factors, wherein the battery life attenuation factors comprise: a temperature T, a battery state of charge (SOC), a number of cycles, and a shelving time t; and the number of cycles is expressed by a capacity throughput E;

    performing a battery cell life test based on the battery life attenuation factors to determine a battery SOH value of a corrected part;

    performing the battery cell life test based on the battery life attenuation factors to determine a battery SOH value of an aging mechanism part;

    constructing an SOH model based on the battery life attenuation factors, the corresponding battery SOH value of the corrected part, and the corresponding battery SOH value of the aging mechanism part, wherein the SOH model takes the battery life attenuation factors as an input and a sum of the battery SOH value of the aging mechanism part and the battery SOH value of the corrected part as an output; and

    estimating an SOH of a lithium battery to be estimated by using the SOH model.

2. The SOH estimation method for a lithium battery according to claim 1, wherein the performing a battery cell life test based on the battery life attenuation factors to determine a battery SOH value of a corrected part specifically comprises:

    determining the battery SOH value of the corrected part by using formula

$$\Delta SOH_{correct} = \Delta SOH_{correct\_}pre \times a + \left(SOH - SOH_{pre}\right) \times (1 - a),$$

    wherein $\Delta SOH_{correct}$ is a battery SOH value of the corrected part at a current time, $\Delta SOH_{correct\_}pre$ is a battery SOH correction amount at a previous time, SOH is a battery SOH value at the current time, $SOH_{pre}$ is a battery SOH value at the previous time, a is a first-order filter coefficient, and an initial value of $\Delta SOH_{correct}$ is 0.

3. The SOH estimation method for a lithium battery according to claim 1, wherein the performing the battery cell life test based on the battery life attenuation factors to determine a battery SOH value of an aging mechanism part specifically comprises:

performing the battery cell life test based on the battery life attenuation factors, wherein the battery cell life test comprises: a shelving test and an application condition cycling test; and performing capacity calibration once a month to check a battery SOH variation;

using a lsqcurvefit function for fitting based on a correspondence between the battery life attenuation factors and a capacity variation to determine calendar life parameters and cycle life parameters, wherein the calendar life parameters comprise: a calendar pre-exponential factor $\alpha1$, a calendar temperature factor $\beta1$, a calendar coefficient $\gamma1$, and a calendar SOC factor 0; and the cycle life parameters comprise: a cycling pre-exponential factor $\alpha2$, a cycling temperature factor $\beta2$, and a cycling coefficient $\gamma2$;

determining a calendar life attenuation amount and a cycle life attenuation amount based on the calendar life parameters and the cycle life parameters; and

determining the battery SOH value of the aging mechanism part based on the calendar life attenuation amount and the cycle life attenuation amount.

4. The SOH estimation method for a lithium battery according to claim 3, wherein the determining a calendar life attenuation amount and a cycle life attenuation amount based on the calendar life parameters and the cycle life parameters specifically comprises:

determining a calendar capacity variation by using formula

$$dCap1 = \alpha1 \times e^{-\beta1/T} \times t^{\gamma1} \times SOC^{\theta};$$

determining a cycling capacity variation by using formula $dCap2 = \alpha2 \times e^{-\beta2/T} \times E^{\gamma2}$;

obtaining a quotient of the calendar capacity variation dCap1 and a rated capacity Q0 to obtain the calendar life attenuation amount $\Delta SOH_{calendar}$; and

obtaining a quotient of the cycling capacity variation dCap2 and the rated capacity Q0 to obtain the cycle life attenuation amount $\Delta SOH_{cycle}$.

5. The SOH estimation method for a lithium battery according to claim 4, wherein the determining the battery SOH value of the aging mechanism part based on the calendar life attenuation amount and the cycle life attenuation amount specifically comprises:

determining the battery SOH value $SOH_{calculate}$ of the aging mechanism part by using formula

$$SOH_{calculate} = 100\% - (\Delta SOH_{calendar} + \Delta SOH_{cycle}).$$

6. An SOH estimation system for a lithium battery, comprising:

a battery life attenuation factor acquisition module, configured to obtain battery life attenuation factors, wherein the battery life attenuation factors comprise: a temperature T, a battery SOC, a number of cycles, and a shelving time t; and the number of cycles is expressed by a capacity throughput E;

a module for determining a battery SOH value of a corrected part, configured to perform a battery cell life test based on the battery life attenuation factors to determine a battery SOH value of a corrected part;

a module for determining a battery SOH value of an aging mechanism part, configured to perform a battery cell life test based on the battery life attenuation factors to determine a battery SOH value of an aging mechanism part;

an SOH model construction module, configured to construct an SOH model based on the battery life attenuation factors, the corresponding battery SOH value of the corrected part, and the corresponding battery SOH value of the aging mechanism part, wherein the SOH model takes the battery life attenuation factors as an input and a sum of the battery SOH value of the aging mechanism part and the battery SOH value of the corrected part as an output; and

an SOH estimation module, configured to estimate an SOH of a lithium battery to be estimated by using the SOH model.

| Obtain battery life attenuation factors | S101 |

↓

| Perform a battery cell life test based on the battery life attenuation factors to determine a battery SOH value of a corrected part | S102 |

↓

| Perform the battery cell life test based on the battery life attenuation factors to determine a battery SOH value of an aging mechanism part | S103 |

↓

| Construct an SOH model based on the battery life attenuation factors, the corresponding battery SOH value of the corrected part, and the corresponding battery SOH value of the aging mechanism part | S104 |

↓

| Estimate an SOH of a lithium battery to be estimated by using the SOH model | S105 |

**FIG. 1**

Europäisches
Patentamt

European
Patent Office

Office européen
des brevets

# EUROPEAN SEARCH REPORT

**Application Number**

EP 24 15 2066

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CN 110 133 535 A (SUNGROW POWER SUPPLY CO LTD) 16 August 2019 (2019-08-16) * abstract * * figures 1-3 * * claims 1-6,8-11 * * Summary of the invention * * Detailed ways * | 1-6 | INV. G01R31/392 G01R31/367 |
| Y | CN 113 406 522 B (HEFEI GUOXUAN HIGH TECH POWER ENERGY CO LTD) 3 May 2022 (2022-05-03) * abstract * * figures 1-4 * * SUMMARY OF THE INVENTION * * Detailed ways * | 1-6 | |
| Y | CN 112 014 736 A (CHINA FAW GROUP CORP) 1 December 2020 (2020-12-01) * abstract; claims 1-3,8 * * figures 1-4 * * Summary of the invention * * Detailed ways * | 1,6 | |
| A | EP 3 842 815 A1 (CHINA LITHIUM BATTERY TECH CO LIMITED [CN]) 30 June 2021 (2021-06-30) * abstract * * figures 1-6 * * paragraphs [0003], [0008] - [0018], [0076] * * claims 1-3,4-5,8 * | 3 | TECHNICAL FIELDS SEARCHED (IPC) G01R |

-/--

The present search report has been drawn up for all claims

| Place of search | Date of completion of the search | Examiner |
|---|---|---|
| The Hague | 5 June 2024 | Mouanda, Thierry |

EPO FORM 1503 03.82 (P04C01)

Europäisches
Patentamt

European
Patent Office

Office européen
des brevets

# EUROPEAN SEARCH REPORT

Application Number

EP 24 15 2066

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WU YITAO ET AL: "State of Health Estimation for Lithium-Ion Batteries Based on Healthy Features and Long Short-Term Memory", IEEE ACCESS, IEEE, USA, vol. 8, 7 February 2020 (2020-02-07), pages 28533-28547, XP011773266, DOI: 10.1109/ACCESS.2020.2972344 [retrieved on 2020-02-13] * abstract * * B. FEATURES EXTRACTION BASED ON IC CURVE * ----- | 1,4,6 | |

**TECHNICAL FIELDS SEARCHED (IPC)**

The present search report has been drawn up for all claims

| Place of search | Date of completion of the search | Examiner |
|---|---|---|
| The Hague | 5 June 2024 | Mouanda, Thierry |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 24 15 2066

This annex lists the patent family members relating to the patent documents cited in the above-mentioned European search report.
The members are as contained in the European Patent Office EDP file on
The European Patent Office is in no way liable for these particulars which are merely given for the purpose of information.

05-06-2024

| Patent document cited in search report | | Publication date | Patent family member(s) | | Publication date |
|---|---|---|---|---|---|
| CN 110133535 | A | 16-08-2019 | NONE | | |
| CN 113406522 | B | 03-05-2022 | NONE | | |
| CN 112014736 | A | 01-12-2020 | NONE | | |
| EP 3842815 | A1 | 30-06-2021 | CN | 111123137 A | 08-05-2020 |
| | | | EP | 3842815 A1 | 30-06-2021 |
| | | | US | 2021194260 A1 | 24-06-2021 |

EPO FORM P0459

For more details about this annex : see Official Journal of the European Patent Office, No. 12/82

**Erroneously filed documents**

**Erroneously filed description (or parts thereof)**

TECHNICAL FIELD

The present disclosure relates to the field of state of health (SOH) estimation of a lithium battery, and in particular, to an SOH estimation method and system for a lithium battery.

BACKGROUND

Lithium-ion batteries are mainly used as traction batteries in the field of new energy vehicles, but the life of lithium batteries will gradually decline with extension of shelving time, an increase in number of cycles, and other factors. An SOH of batteries has aroused widespread attention of researchers. The SOH represents a ratio of a fully charged capacity of the battery under current conditions to a rated capacity at delivery. It is generally believed that 70%SOH is the service life limit of the battery, and the battery needs to be replaced with a new one at this time. The SOH directly affects the service life of the battery and an endurance mileage of a vehicle. Accurate estimation of the SOH is also related to estimation of a state of charge (SOC) of the battery and affects experience of a vehicle user.

Common SOH estimation methods in engineering mainly include a direct current internal resistance (DCR) estimation method, an open circuit voltage (OCV) calibration method, and the like. The DCR estimation method is to obtain an internal resistance increment based on DCR testing, and look up an internal resistance increment-capacity fading table to determine a capacity fading value, so as to estimate an SOH. The DCR estimation method has convenience in testing, but it is difficult to obtain a peak current during calculation of internal resistance, and the method relies heavily on synchronization of voltage and current sampling, so that a large error is likely to occur in calculation of the internal resistance, and the SOH obtained by looking up the table based on the internal resistance increment may be inaccurate. The OCV calibration method is to check an SOC based on to an OCV in a steep range of an OCV curve, and calculate an SOH based on a recorded ampere-hour integral variation and SOC variation. The OCV calibration method is relatively simple, but this SOH estimation method relies heavily on accuracy of an OCV-SOC curve, and is restricted by a static battery condition, so that accuracy of SOH estimation is limited.

Therefore, there is an urgent need to provide an SOH estimation method or system for a lithium battery, which can solve the problem of large errors in SOH estimation of a lithium battery, thereby accurately estimating an SOH.

SUMMARY

An objective of the present disclosure is to provide an SOH estimation method and system for a lithium battery, which can accurately estimate an SOH.

To achieve the above objective, the present disclosure provides the following solutions.

An SOH estimation method for a lithium battery includes:

obtaining battery life attenuation factors, where the battery life attenuation factors include: a temperature T, a battery SOC, a number of cycles, and a shelving time t; and the number of cycles is expressed by a capacity throughput E;

performing a battery cell life test based on the battery life attenuation factors to determine a battery SOH value of a corrected part;

performing the battery cell life test based on the battery life attenuation factors to determine a battery SOH value of an aging mechanism part;

constructing an SOH model based on the battery life attenuation factors, the corresponding battery SOH value of the corrected part, and the corresponding battery SOH value of the aging mechanism part, where the SOH model takes the battery life attenuation factors as an input and a sum of the battery SOH value of the aging mechanism part and the battery SOH value of the corrected part as an output; and

estimating an SOH of a lithium battery to be estimated by using the SOH model.

Optionally, the performing a battery cell life test based on the battery life attenuation factors to determine a battery SOH value of a corrected part specifically includes:

determining the battery SOH value of the corrected part by using formula $\Delta SOH_{correct} = \Delta SOH_{correct\_pre} \times a + (SOH - SOH_{pre}) \times (1 - a)$,

where $\Delta SOH_{correct}$ is a battery SOH value of the corrected part at a current time, $\Delta SOH_{correct\_pre}$ is a battery SOH correction amount at a previous time, SOH is a battery SOH value at the current time, $SOH_{pre}$ is a battery SOH value at the previous time, a is a first-order filter coefficient, and an initial value of $\Delta SOH_{correct}$ is 0.

Optionally, the performing the battery cell life test based on the battery life attenuation factors to determine a battery SOH value of an aging mechanism part specifically includes:

performing the battery cell life test based on the battery life attenuation factors, where the battery cell life test includes: a shelving test and an application condition cycling test; and performing capacity calibration once a month to check a battery SOH variation;

using a lsqcurvefit function for fitting based on a correspondence between the battery life attenuation factors and a capacity variation to determine calendar life parameters and cycle life parameters, where the calendar life parameter includes: a calendar pre-exponential factor $\alpha1$, a calendar temperature factor $\beta1$, a calendar coefficient $\gamma1$, and a calendar SOC factor $\theta$; and the cycle life parameter includes: a cycling pre-exponential factor $\alpha2$, a cycling temperature factor $\beta2$, and a cycling coefficient $\gamma2$;

determining a calendar life attenuation amount and a cycle life attenuation amount based on the calendar life parameters and the cycle life parameters; and

determining the battery SOH value of the aging mechanism part based on the calendar life attenuation amount and the cycle life attenuation amount.

Optionally, the determining a calendar life attenuation amount and a cycle life attenuation amount based on the calendar life parameters and the cycle life parameters specifically includes:

determining a calendar capacity variation by using formula $\boldsymbol{dCap1 = a1 \times e^{-\beta 2/T} \times t^{\gamma 1} \times SOC^{\theta}}$;

determining a cycling capacity variation by using formula $\boldsymbol{dCap2 = a2 \times e^{-\beta 2/T} \times E^{\gamma 2}}$;

obtaining a quotient of the calendar capacity variation dCap1 and a rated capacity Q0 to obtain the calendar life attenuation amount $\Delta SOH_{calendar}$; and

obtaining a quotient of the cycling capacity variation dCap2 and the rated capacity Q0 to obtain the cycle life attenuation amount $\Delta SOH_{cycle}$.

Optionally, the determining the battery SOH value of the aging mechanism part based on the calendar life attenuation amount and the cycle life attenuation amount specifically includes:

determining the battery SOH value $SOH_{calculate}$ of the aging mechanism part by using formula $SOH_{calculate} = 100\% - (\Delta SOH_{calendar} + \Delta SOH_{cycle})$.

An SOH estimation system for a lithium battery includes:

a battery life attenuation factor acquisition module, configured to obtain battery life attenuation factors, where the battery life attenuation factors include: a temperature T, a battery SOC, a number of cycles, and a shelving time t; and the number of cycles is expressed by a capacity throughput E;

a module for determining a battery SOH value of a corrected part, configured to perform a battery cell life test based on the battery life attenuation factors to determine a battery SOH value of a corrected part;

a module for determining a battery SOH value of an aging mechanism part, configured to perform a battery cell life test based on the battery life attenuation factors to determine a battery SOH value of an aging mechanism part;

an SOH model construction module, configured to construct an SOH model based on the battery life attenuation factors, the corresponding battery SOH value of the corrected part, and the corresponding battery SOH value of the aging mechanism part, where the SOH model takes the battery life attenuation factors as an input and a sum of the battery SOH value of the aging mechanism part and the battery SOH value of the corrected part as an output; and

an SOH estimation module, configured to estimate an SOH of a lithium battery to be estimated by using the SOH model.

According to specific embodiments of the present disclosure, the present disclosure has the following technical effects:

In the SOH estimation method and system for a lithium battery, a battery SOH value of a corrected part and a battery SOH value of an aging mechanism part are determined based on a battery cell life test, and then an SOH is estimated; estimating the SOH based on battery life test data overcomes high dependence of a DCR estimation method on synchronization of voltage and current sampling; and the present disclosure is not restricted by a static condition, and avoids the dependence of an OCV calibration method on accuracy of an OCV-SOC curve.

## BRIEF DESCRIPTION OF THE DRAWINGS

To describe the technical solutions in embodiments of the present disclosure or in the prior art more clearly, the accompanying drawings required for the embodiments are briefly described below. Apparently, the accompanying drawings in the following description show merely some embodiments of the present disclosure, and those of ordinary skill in the art may still derive other accompanying drawings from these accompanying drawings without creative efforts.

FIG. 1 is a schematic flowchart of an SOH estimation method for a lithium battery according to the present disclosure.

## DETAILED DESCRIPTION OF THE EMBODIMENTS

The technical solutions of the embodiments of the present disclosure are clearly and completely described below with reference to the accompanying drawings in the embodiments of the present disclosure. Apparently, the described embodiments are merely some rather than all of the embodiments of the present disclosure. All other embodiments obtained by those skilled in the art based on the embodiments of the present disclosure without creative efforts shall fall within the protection scope of the present disclosure.

An objective of the present disclosure is to provide an SOH estimation method and system for a lithium battery, which can accurately estimate an SOH.

In order to make the above objective, features and advantages of the present disclosure clearer and more comprehensible, the present disclosure will be further described in detail below in combination with accompanying drawings and specific implementations.

As shown in FIG. 1, an SOH estimation method for a lithium battery according to the present disclosure includes the following steps.

S101: Obtain battery life attenuation factors, where the battery life attenuation factors include: a temperature T, a battery SOC, a number of cycles, and a shelving time t; and the number of cycles is expressed by a capacity throughput E.

A higher temperature indicates a higher electrochemical reaction rate and faster capacity fading; a higher SOC indicates a higher electrolyte decomposition rate, higher consumption of active lithium and faster battery aging; a larger number of cycles, that is, a greater capacity throughput, indicates a faster battery loss and faster capacity fading; and a longer shelving time of a battery indicates more severe battery self-discharge and faster capacity fading.

S102: Perform a battery cell life test based on the battery life attenuation factors to determine a battery SOH value of a corrected part.

This step specifically includes:

determining the battery SOH value of the corrected part by using formula $\Delta SOH_{correct} = \Delta SOH_{correct\_pre} \times a + (SOH - SOH_{pre}) \times (1 - a)$,

where $\Delta SOH_{correct}$ is a battery SOH value of the corrected part at a current time, $\Delta SOH_{correct\_pre}$ is a battery SOH correction amount at a previous time, SOH is a battery SOH value at the current time, $SOH_{pre}$ is a battery SOH value at the previous time, a is a first-order filter coefficient, and an initial value of $\Delta SOH_{correct}$ is 0.

S103: Perform the battery cell life test based on the battery life attenuation factors to determine a battery SOH value of an aging mechanism part.

Step S103 specifically includes:

performing the battery cell life test based on the battery life attenuation factors, where the battery cell life test includes: a shelving test and an application condition cycling test; and performing capacity calibration once a month to check a battery SOH variation.

The performing the battery cell life test specifically includes the following steps.

S1: Arrange and combine SOCs and temperatures T, and perform shelving tests at corresponding SOCs and temperatures T respectively to obtain SOH calendar life variations, where selected SOCs and temperatures T should cover each range.

S2: Arrange and combine the temperatures T, and perform application condition cycling tests at the corresponding temperatures T respectively to obtain SOH cycle life variations, where the selected temperatures T should cover each range.

S3: Use two packs of battery cells as parallel samples under each working condition for the shelving tests and the cycling tests to obtain shelving test data and application condition cycling test data, where the two packs of battery cells are under the same working condition to reduce the influence of experimental errors.

S4: Perform capacity calibration once a month to obtain a variation dCap1 of a shelving test capacity and a variation dCap2 of a cycling test capacity.

There are 9 corresponding shelving test conditions. Two packs of new battery cells in the same state are selected as parallel samples for each working condition, and shelving is performed in the case of 20%SOC at 10°C, 50% SOC at 10°C, 100%SOC at 10°C, 20%SOC at 25°C, 50%SOC at 25°C, 100%SOC at 25°C, 20%SOC at 35°C, 50%SOC at 35°C, and 100%SOC at 35°C. The shelving time t is counted from 0, and each month is used as an SOH inspection cycle. The capacity variation is calculated by capacity calibration until the SOH is reduced to 70%.

For application condition cycling tests, specific implementation examples are as follows.

For example, the temperature T is set to 10°C, 25°C, 35°C, 45°C, and 55°C.

There are 5 corresponding application condition cycling test conditions. Two packs of new battery cells in the same state are selected as parallel samples for each working condition, and cycling is performed at 10°C, 25°C, 35°C, 45°C, and 55°C. The number of cycles is represented by the capacity throughput E (in Ah). E is counted from 0, and each month is used as an SOH inspection cycle. The capacity variation is calculated by capacity calibration until the SOH is reduced to 70%.

A lsqcurvefit function is used for fitting based on a correspondence between the battery life attenuation factors and a capacity variation to determine calendar life parameters and cycle life parameters, where the calendar life parameter includes: a calendar pre-exponential factor $\alpha1$, a calendar temperature factor $\beta1$, a calendar coefficient $\gamma1$, and a calendar SOC factor $\theta$; and the cycle life parameter includes: a cycling pre-exponential factor $\alpha2$, a cycling temperature factor $\beta2$, and a cycling coefficient $\gamma2$.

A calendar life attenuation amount and a cycle life attenuation amount are determined based on the calendar life parameters and the cycle life parameters.

The battery SOH value of the aging mechanism part is determined based on the calendar life attenuation amount and the cycle life attenuation amount.

A calendar capacity variation is determined by using formula

$$dCap1 = \alpha1 \times e^{-\beta1/T} \times t^{\gamma1} \times SOC^{\theta}.$$

A cycling capacity variation is determined by using formula $dCap2 = a2 \times e^{-\beta2/T} \times E^{\gamma2}.$

A quotient of the calendar capacity variation dCap1 and a rated capacity Q0 is obtained to obtain the calendar life attenuation amount $\Delta SOH_{calendar}$.

A quotient of the cycling capacity variation dCap2 and the rated capacity Q0 is obtained to obtain the cycle life attenuation amount $\Delta SOH_{cycle}$.

The battery SOH value $SOH_{calculate}$ of the aging mechanism part is determined by using formula $SOH_{calculate} = 100\% - (\Delta SOH_{calendar} + \Delta SOH_{cycle})$.

A change rate of the SOH is limited, and a Simulink model changes by 0.01%SOH at most for each calculation.

The SOH of the lithium battery is not corrected upward, and the SOH value is between 70% and 100%.

S104: Construct an SOH model based on the battery life attenuation factors, the corresponding battery SOH value of the corrected part, and the corresponding battery SOH value of the aging mechanism part, where the SOH model takes the battery life attenuation factors as an input and a sum of the battery SOH value of the aging mechanism part and the battery SOH value of the corrected part as an output.

The SOH model is:

$SOH = SOH_{calculate} + \Delta SOH_{correct}$ or $SOH = fcn(t,T,SOC,E) + \Delta SOH_{correct}$, where $SOH_{calculate}$ is fcn(t,T,SOC,E) and represents a calculated SOH of the aging mechanism part. $\Delta SOH_{correct}$ represents the battery SOH value of the corrected part, which is calculated based on first-order filtering of the SOH variation.

S105: Estimate an SOH of a lithium battery to be estimated by using the SOH model.

The present disclosure provides the SOH estimation method for a lithium battery based on a battery cell life test, which fits test data by using empirical formula and the lsqcurvefit function, and calculates the SOH of the aging mechanism part from two aspects of calendar life and cycle life, to accurately estimate the SOH, thereby solving the problem of large errors in SOH estimation of the lithium battery. Estimating the SOH based on systematic battery life test data overcomes high dependence of a DCR estimation method on synchronization of voltage and current sampling; and the method is not restricted by a static condition, and avoids the dependence of an OCV calibration method on accuracy of an OCV-SOC curve.

Corresponding to the method of the above embodiment, the present disclosure further provides an SOH estimation system for a lithium battery, including:

a battery life attenuation factor acquisition module, configured to obtain battery life attenuation factors, where the battery life attenuation factors include: a temperature T, a battery SOC, a number of cycles, and a shelving time t; and the number of cycles is expressed by a capacity throughput E;

a module for determining a battery SOH value of a corrected part, configured to perform a battery cell life test based on the battery life attenuation factors to determine a battery SOH value of a corrected part;

a module for determining a battery SOH value of an aging mechanism part, configured to perform a battery cell life test based on the battery life attenuation factors to determine a battery SOH value of an aging mechanism part;

an SOH model construction module, configured to construct an SOH model based on the battery life attenuation factors, the corresponding battery SOH value of the corrected part, and the corresponding battery SOH value of the aging mechanism part, where the SOH model takes the battery life attenuation factors as an input and a sum of the battery SOH value of the aging mechanism part and the battery SOH value of the corrected part as an output; and

an SOH estimation module, configured to estimate an SOH of a lithium battery to be estimated by using the SOH model.

Embodiments of this description are described in a progressive manner, each embodiment focuses on the difference from other embodiments, and for the same and similar parts between the embodiments, reference may be made to each other. Since the system disclosed in an embodiment corresponds to the method disclosed in an embodiment, the description is relatively simple, and for related contents, reference may be made to the description of the method.

Specific examples are used herein for illustration of principles and implementations of the present disclosure. The descriptions of the above embodiments are merely used for assisting in understanding the method of the present disclosure and its core ideas. In addition, those of ordinary skill in the art can make various changes in terms of specific implementations and the scope of application in accordance with the ideas of the present disclosure. In conclusion, the content of this description shall not be construed as limitations to the present disclosure.

**Erroneously filed claims (or parts thereof)**

1. A state of health (SOH) estimation method for a lithium battery, comprising:

obtaining battery life attenuation factors, wherein the battery life attenuation factors comprise: a temperature T, a battery state of charge (SOC), a number of cycles, and a shelving time t; and the number of cycles is expressed by a capacity throughput E;

performing a battery cell life test based on the battery life attenuation factors to determine a battery SOH value of a corrected part;

performing the battery cell life test based on the battery life attenuation factors to determine a battery SOH value of an aging mechanism part;

constructing an SOH model based on the battery life attenuation factors, the corresponding battery SOH value of the corrected part, and the corresponding battery SOH value of the aging mechanism part, wherein the SOH model takes the battery life attenuation factors as an input and a sum of the battery SOH value of the aging mechanism part and the battery SOH value of the corrected part as an output; and

estimating an SOH of a lithium battery to be estimated by using the SOH model.

2. The SOH estimation method for a lithium battery according to claim 1, wherein the performing a battery cell life test based on the battery life attenuation factors to determine a battery SOH value of a corrected part specifically comprises:

determining the battery SOH value of the corrected part by using formula $\Delta SOH_{correct} = \Delta SOH_{correct\_pre} \times a + (SOH - SOH_{pre}) \times (1 - a)$,

wherein $\Delta SOH_{correct}$ is a battery SOH value of the corrected part at a current time, $\Delta SOH_{correct\_pre}$ is a battery SOH correction amount at a previous time, SOH is a battery SOH value at the current time, $SOH_{pre}$ is a battery SOH value at the previous time, a is a first-order filter coefficient, and an initial value of $\Delta SOH_{correct}$ is 0.

3. The SOH estimation method for a lithium battery according to claim 1, wherein the performing the battery cell life test based on the battery life attenuation factors to determine a battery SOH value of an aging mechanism part specifically comprises:

performing the battery cell life test based on the battery life attenuation factors, wherein the battery cell life test comprises: a shelving test and an application condition cycling test; and performing capacity calibration once a month to check a battery SOH variation;

using a lsqcurvefit function for fitting based on a correspondence between the battery life attenuation factors and a capacity variation to determine calendar life parameters and cycle life parameters, wherein the calendar life parameters comprise: a calendar pre-exponential factor $\alpha1$, a calendar temperature factor $\beta1$, a calendar coefficient $\gamma1$, and a calendar SOC factor $\theta$; and the cycle life parameters comprise: a cycling pre-exponential factor $\alpha2$, a cycling temperature factor $\beta2$, and a cycling coefficient $\gamma2$;

determining a calendar life attenuation amount and a cycle life attenuation amount based on the calendar life parameters and the cycle life parameters; and

determining the battery SOH value of the aging mechanism part based on the calendar life attenuation amount and the cycle life attenuation amount.

4. The SOH estimation method for a lithium battery according to claim 3, wherein the determining a calendar life attenuation amount and a cycle life attenuation amount based on the calendar life parameters and the cycle life parameters specifically comprises:

determining a calendar capacity variation by using formula $dCap1 = a1 \times e^{-\beta2/T} \times t^{\gamma1} \times SOC^{\theta}$;

determining a cycling capacity variation by using formula $dCap2 = a2 \times e^{-\beta2/T} \times E^{\gamma2}$;

obtaining a quotient of the calendar capacity variation dCap1 and a rated capacity Q0 to obtain the calendar life attenuation amount $\Delta SOH_{calendar}$; and

obtaining a quotient of the cycling capacity variation dCap2 and the rated capacity Q0 to obtain the cycle life attenuation amount $\Delta SOH_{cycle}$.

5. The SOH estimation method for a lithium battery according to claim 4, wherein the determining the battery SOH value of the aging mechanism part based on the calendar life attenuation amount and the cycle life attenuation amount specifically comprises:

determining the battery SOH value $SOH_{calculate}$ of the aging mechanism part by using formula $SOH_{calculate} = 100\% - (\Delta SOH_{calendar} + \Delta SOH_{cycle})$.

6. An SOH estimation system for a lithium battery, comprising:

a battery life attenuation factor acquisition module, configured to obtain battery life attenuation factors, wherein the battery life attenuation factors comprise: a temperature T, a battery SOC, a number of cycles, and a shelving time t; and the number of cycles is expressed by a capacity throughput E;

a module for determining a battery SOH value of a corrected part, configured to perform a battery cell life test based on the battery life attenuation factors to determine a battery SOH value of a corrected part;

a module for determining a battery SOH value of an aging mechanism part, configured to perform a battery cell life test based on the battery life attenuation factors to determine a battery SOH value of an aging mechanism part;

an SOH model construction module, configured to construct an SOH model based on the battery life attenuation factors, the corresponding battery SOH value of the corrected part, and the corresponding battery SOH value of the aging mechanism part, wherein the SOH model takes the battery life attenuation factors as an input and a sum of the battery SOH value of the aging mechanism part and the battery SOH value of the corrected part as an output; and

an SOH estimation module, configured to estimate an SOH of a lithium battery to be estimated by using the SOH model.